# EUROPÄISCHE PATENTSCHRIFT

(11) **EP 0 534 402 B1**
(45) Veröffentlichungstag und Bekanntmachung des Hinweises auf die Patenterteilung: **20.11.1996**
(21) Anmeldenummer: 92116279.8
(22) Anmeldetag: 23.09.1992
(51) Int. Cl.: G11B 33/12, G11B 33/02, H05K 7/14

(54) **Vorrichtung zum Entsperren eines federnd vorgespannten Rastelements an der Seite einer Einschubeinheit**
Device to release a resiliently biased latch member on the side of a rack
Dispositif de déverrouillae d'un organe d'accrochage sous tension élastique, sur le côté d'un tiroir

(30) Priorität: 23.09.1991 DE 4131661
(43) Veröffentlichungstag der Anmeldung: 31.03.1993
(73) Patentinhaber: Siemens Nixdorf Informationssysteme Aktiengesellschaft, 33102 Paderborn (DE)
(72) Erfinder: Fietz, Ralf-Peter, W-4790 Paderborn-Elsen (DE)
(74) Vertreter: Fuchs, Franz-Josef, Dr.-Ing.

(56) Entgegenhaltungen:
- DE-A- 3 505 190
- DE-U- 8 708 842
- FR-A- 1 173 899
- US-A- 4 580 192

## Beschreibung

Die Erfindung betrifft eine Vorrichtung zum Entsperren eines federnd vorgespannten Rastelements an der Seite einer elektronischen Einschubeinheit nach dem Oberbegriff des Anspruchs 1.

Derartige Vorrichtungen ermöglichen einerseits die stabile Befestigung einer Einschubeinheit in einem Baugruppenträger und andererseits den schnellen Austausch der Einschubeinheit gegen eine andere. Ein typischer Anwendungsfall ist in der Elektroindustrie beim Ausrüsten von Schaltschränken mit Einschubeinheiten gegeben, die verschiedene Elektronikgeräte, beispielsweise Magnetplatten- oder Diskettenlaufwerke, aufnehmen. Beim Austausch eines solchen Gerätes gegen ein anderes wird die Einschubeinheit entsperrt, aus dem Schaltschrank herausgezogen und das von der Einschubeinheit gehaltene Gerät gegen ein anderes ausgetauscht. Anschließend wird die Einschubeinheit wieder in den Schaltschrank eingeschoben und dort mittels des Rastelements arretiert.

Bei einer bekannten Vorrichtung muß der Bediener das Rastelement mit dem Finger ertasten und durch Fingerdruck entsperren. Nachteilig ist bei einer solchen Vorrichtung, daß eine Öffnung für den Finger zwischen dem Baugruppenträger und der Einschubeinheit vorgesehen sein muß und daß das Entsperren eine erhebliche Geschicklichkeit des Bedieners erfordert. Demgemäß muß ein umständliches Hantieren mit der Einschubeinheit oder eine ungünstige Ausnutzung des insgesamt durch den Baugruppenträger bereitgestellten Raumangebots in Kauf genommen werden.

Aus der FR-A-1 173 889 ist eine Vorrichtung zum Verriegeln, Kuppeln und Entkuppeln einer auf einem Träger geführten Einschubeinheit bekannt, die im auf den Träger aufgeschobenen Zustand mit einem Steckverbindungssystem verbunden und verrastet ist und in Richtung der Ausziehbewegung der Einschubeinheit lösbar ist. An einer Seite der Einschubeinheit ist ein Entsperrhebel schwenkbar gelagert. An diesem ist ein erstes Rastelement angebracht, das bei auf den Träger aufgeschobener Einschubeinheit in eine Rastöffnung des Trägers eingreift. In dieser Position steht der Entsperrhebel senkrecht von der Frontseite der Einschubeinheit ab und ruht auf dem Träger. Zum Entsperren wird der Entsperrhebel zunächst angehoben, wodurch das erste Rastelement gelöst wird. Danach kann die Einschubeinheit entgegen der Aufschubrichtung so weit von dem Träger gezogen werden, daß der Entsperrhebel von dem Träger freikommt. Das Steckverbindungssystem wird dabei durch ein zweites Rastelement mit der Einschubeinheit nach vorne gezogen. Durch Verschwenken des Entsperrhebels in eine über die Unterseite der Einschubeinheit hinausragende Position wird auch diese Verrastung gelöst, so daß die Einschubeinheit vollends von dem Träger gezogen werden kann. Der Baugruppenträger hat bei dieser Anordnung eine Tiefe, die weit über die Länge der Einschubeinheit hinausgeht. Außerdem muß der Entsperrhebel in einer fest vorgegebenen Reihenfolge in mehrere unterschiedliche Positionen verschwenkt werden.

Es ist Aufgabe der Erfindung, eine Vorrichtung anzugeben, bei der mit nur einer Hebelbewegung die Einschubeinheit entriegelt und die elektrische Verbindung zwischen Einschubeinheit und Baugruppenträger gleichmäßig und materialschonend gelöst werden kann.

Diese Aufgabe wird durch die Merkmale des Patentanspruchs 1 gelöst. Vorteilhafte Weiterbildungen sind in den Unteransprüchen angegeben.

Gemäß der Erfindung hat der erste Hebelabschnitt einen vorzugsweise rampenförmigen Axialnokken, dessen Axialhub mindestens gleich dem Bewegungshub des Rastelements zwischen dessen Einrast- und Entsperrstellung ist und der mit dem Rastelement in Eingriff steht.

Bei der Schwenkbewegung des Entsperrhebels um seine Schwenkachse drückt der Axialnocken das Rastelement gegen die Federkraft aus der Rastöffung des Baugruppenträgers. Danach ist die Einschubeinheit vom Baugruppenträger gelöst und kann aus diesem herausgezogen werden. Wenn der Axialnocken eine Rampenform hat, so definiert deren Steigung den Hub des Rastelements beim Drehen des Entsperrhebels. Durch Wahl der Steigung der Rampe und durch deren Drehwinkel kann der Gesamthub sowie die bei der Schwenkbewegung aufzuwendende Kraft auf einfache Weise festgelegt werden.

In einer Ausgestaltung des vorgenannten Merkmals steht im eingeschobenen Zustand der Einschubeinheit eine Nase des Rastelements einem Anfangsabschnitt des rampenförmigen Axialnockens gegenüber, wobei der Axialnocken vorzugsweise einen Drehwinkel von ca. 45° überdeckt.

Dadurch drückt die Nase des federbelasteten Rastelements in eingerasteter Stellung der Einschubeinheit gegen die Rampe des Axialnockens. Das dadurch erzeugte Drehmoment drückt den Entsperrhebel in seine Ruhestellung. In dieser wird er sicher gehalten, auch dann, wenn auf den Baugruppenträger äußere Kräfte, z.B. Rüttelkräfte, einwirken. Die Betriebssicherheit der Einschubeinheit wird dadurch erhöht.

Wird als Drehwinkel für den wirksamen Abschnitt des Axialnockens 45° gewählt, wobei der gesamte Schwenkbereich des Entsperrhebels größer als 45° ist, so teilt sich die gesamte Schwenkbewegung in zwei Phasen auf. In einer ersten Phase wird dann das Rastelement entriegelt, während in der sich anschließenden zweiten Phase die Einschubeinheit bereits vom Baugruppenträger gelöst ist und im weiteren Verlauf der Schwenkbewegung herausgezogen werden kann. Dadurch wird ein fließender Bewegungsübergang von Schwenk- und Ausziehbewegung erreicht.

Bei der Erfindung hat ferner der erste Hebelabschnitt einen Radialnocken, der gegen ein mit dem Baugruppenträger verbundenes Gegenlager bewegbar ist.

Dadurch wird mit der Schwenkbewegung auch eine in Ausziehrichtung der Einschubeinheit gerichtete Linearbewegung bewirkt. Die durch den Radialnocken gegen das Gegenlager erzeugte Hebelkraft ermöglicht ein Herausziehen der Einschubeinheit mit verringertem Kraftaufwand. Dies ist besonders dann vorteilhaft, wenn die Einschubeinheit im Baugruppenträger mit einer weiteren Vorrichtung verbunden ist, beispielsweise einem elektrischen Verbindungssystem, aus dem es im ersten Bewegungsabschnitt beim Herausziehen der Einschubeinheit gelöst werden muß. Der Radialnocken wirkt dann über den Hebelarm des ersten Hebelabschnitts als Hilfseinrichtung zum Überwinden der anfänglich hohen Festhaltekraft der Kontakte. Beim vorgenannten Ausführungsbeispiel übernimmt also der Entsperrhebel neben seinen Funktionen als Entsperrglied und als Griff noch die Funktion eines Ausziehwerkzeugs, das das Loslösen der Einschubeinheit aus dem Baugruppenträger unterstützt.

In einer bevorzugten Weiterbildung der Erfindung ist die Schwenkbewegung des Entsperrhebels durch Anschläge auf einen Schwenkbereich von vorzugsweise 90° beschränkbar.

Durch diese Maßnahmen werden zwei Endstellungen des Entsperrhebels definiert, so daß es möglich wird, den Entsperrhebel in der eingerasteten Stellung der Einschubeinheit in eine Ruhestellung zu bringen, in der er den weiteren Betrieb der Einschubeinheit nicht stören kann. In seiner anderen Endstellung dient ein Anschlag als Auflager für den zweiten Hebelabschnitt, um beim Herausziehen der Einschubeinheit eine stabile mechanische Führung sowie eine günstige Kraftübertragung zu erhalten.

Bei einer anderen vorteilhaften Fortbildung ist an der Außenseite der Einschubeinheit eine metallische Kontaktfeder vorgesehen, die mit dem metallischen Baugruppenträger federnd in Kontakt steht und die mit einem von der Einschubeinheit gehaltenen Gerät leitend verbindbar ist.

Durch diese Maßnahmen wird zwischen dem Gerät und dem Baugruppenträger eine elektrisch leitende Verbindung hergestellt. Diese dient zur Ableitung unerwünschter Störströme und stellt am Gerät ein definiertes Potential ein. Dadurch werden die Erfordernisse an die elektromagnetische Verträglichkeit (EMV) elektronischer Geräte auf einfache und sichere Weise erfüllt.

Die vorgenannte Fortbildung kann derart ausgeführt sein, daß das Rastelement zwischen der Außenseite der Einschubeinheit und der Kontaktfeder einklemmbar ist.

Durch diese Maßnahme werden die Federeigenschaften der Kontaktfeder auch für das Rastelement genutzt. Weiterhin können durch diese einfache konstruktive Lösung Montageteile eingespart und der Zusammenbau der Einschubeinheit vereinfacht werden.

Eine weitere konstruktive Vereinfachung ergibt sich, wenn auf der Außenseite der Einschubeinheit Klemmrippen vorgesehen sind, auf die die Kontaktfeder klemmend aufsteckbar ist. Dadurch wird eine selbstverstärkende Klemmung der Kontaktfeder unter Ausnutzung ihrer Federeigenschaften erreicht.

Eine andere Weiterbildung ist dadurch gekennzeichnet, daß die Einschubeinheit als U-förmiger Kunststoffbügel ausgebildet ist, der durch Spritzgießen herstellbar ist. Durch diese Maßnahme erhält die Einschubeinheit eine stabile Form und läßt sich mittels Führungen an den Schenkeln auf einfache Weise in den Baugruppenträger einschieben. Das Gerät kann zwischen den Schenkeln des Kunststoffbügels aufgenommen werden, wobei es ausreichend sein kann, die Vorrichtung zum Entsperren an nur einem Schenkel vorzusehen. Die Ausbildung als Spritzgußteil ist vorteilhaft, da so der Kunststoffbügel mit engen Toleranzen und in großer Stückzahl hergestellt werden kann.

Eine bevorzugte Weiterbildung ist dadurch gekennzeichnet, daß die Einschubeinheit ein Magnetplattenlaufwerk oder ein Magnetbandlaufwerk aufnimmt. Derartige Laufwerke erzeugen aufgrund ihres elektromechanischen Antriebs Vibrationen. Da gemäß der Erfindung das Rastelement mit dem Baugruppenträger verbunden ist, wird ein Lösen der Einschubeinheit aus dem Baugruppenträger beim Betrieb der Laufwerke verhindert.

Ein Ausführungsbeispiel der Erfindung wird im folgenden an Hand der Zeichnungen erläutert. Darin zeigen:
- Fig. 1: eine schematische Darstellung eines Schaltschrankes mit mehreren Einschubeinheiten,
- Fig. 2: eine Einschubeinheit mit einem Steckverbindersystem,
- Fig. 3: die einzelnen Bauteile einer Verriegelungsvorrichtung,
- Fig. 4: Teile der Verriegelungsvorrichtung in einer Draufsicht,
- Fig. 5: die Verriegelungsvorrichtung in verschiedenen Stellungen der Einschubeinheit, und
- Fig. 6: die Verriegelungsvorrichtung in verschiedenen Schwenkstellungen des Entsperrhebels.

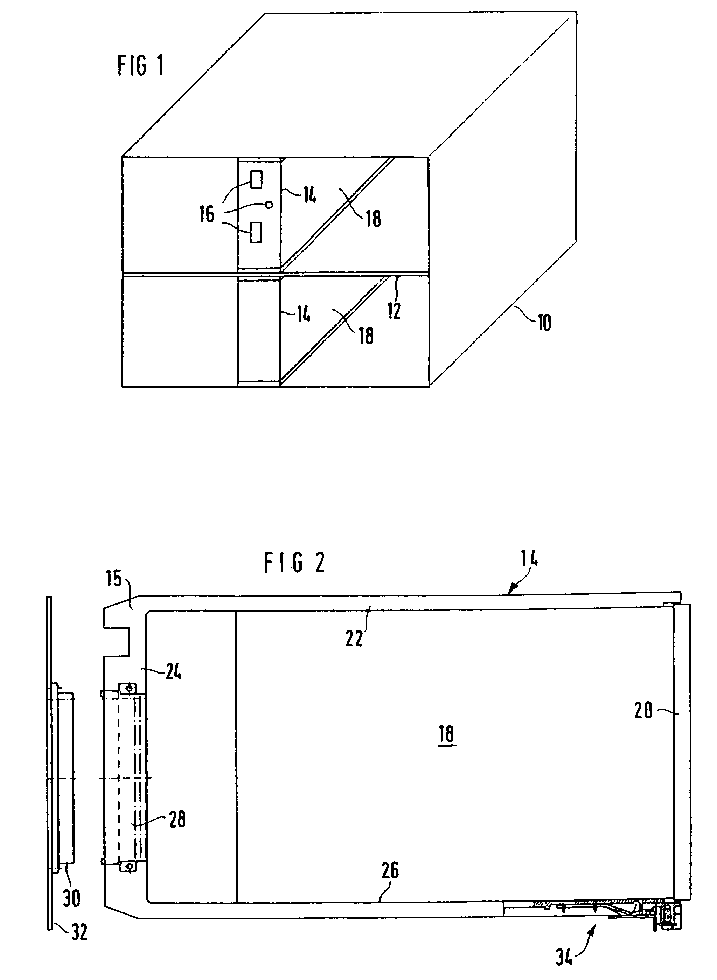

In Fig. 1 ist ein elektrischer Schaltschrank 10 eines Computers dargestellt. In den Schaltschrank 10 sind Einschubeinheiten 14 in einem als Baugruppenträger dienenden Einschubrahmen 12 eingeschoben. Die Einschubeinheiten 14 nehmen elektrische Geräte 18 auf, beispielsweise Computerperipheriegeräte, wie Diskettenlaufwerke oder Magnetplattenspeicher. Auf der Frontseite einer Einschubeinheit 14 sind Bedien- bzw. Anzeigeelemente 16 angeordnet.

In Fig. 2 ist eine Einschubeinheit 14 näher dargestellt. Sie besteht aus einem im Spritzgußverfahren hergestellten Kunststoffbügel 15 mit Schenkeln 22, 26, zwischen denen das elektrische Gerät 18 gehalten wird. Die Basis 24 des Kunststoffbügels 15 trägt einen elektrischen Verbindungsstecker 28, der mit einer entsprechenden Verbindungsbuchse 30, die auf einem rückseitigen Träger des Einschubrahmens 12 befestigt ist, verbunden werden kann. Im vorderen Abschnitt des Schenkels 26 ist eine Verriegelungsvorrichtung 34 angeordnet, die nachfolgend noch näher beschrieben wird. Die Verriegelungsvorrichtung 34 schließt etwa bündig mit einer Frontwand 20 des elektrischen Gerätes 18, d.h. mit der Frontebene der Einschubeinheit ab.

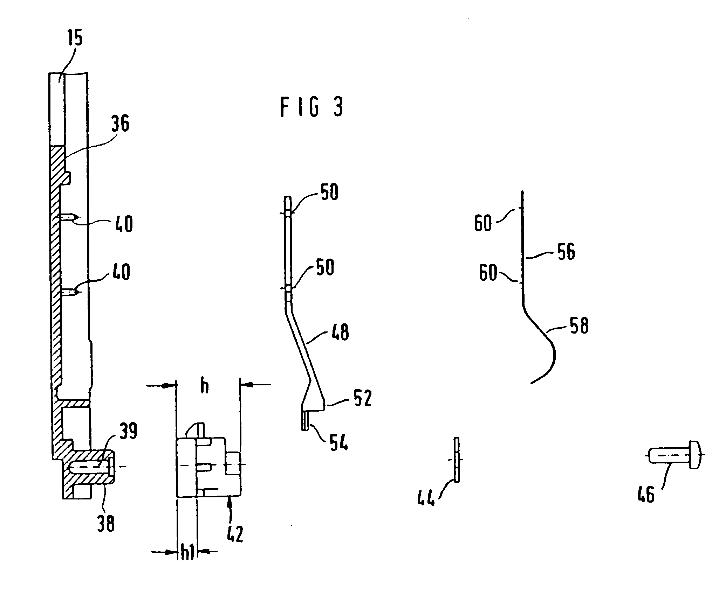

In Fig. 3 sind die einzelnen Bauteile, aus denen sich die Verriegelungsvorrichtung 34 zusammensetzt, dargestellt. Eine Grundplatte 36, die einstückig mit dem Kunststoffbügel 15 verbunden ist, hat im vorderen, der Frontplatte 20 zugewandten Abschnitt einen Zapfen 38 mit einer Gewindebohrung 39. Auf diesen Zapfen 38 wird beim Zusammenbau der Verriegelungsvorrichtung 34 ein Entsperrhebel 42 gesteckt, der mittels einer Unterlagscheibe 44 und einer Schraube 46, die in die Gewindebohrung 39 geschraubt wird, mit dem Zapfen 38 schwenkbar verbunden wird. Als weiteres Bauteil ist ein aus Kunststoff bestehendes Rastelement 48 mit einer Raste 52 vorgesehen, von der eine Nase 54 absteht. Eine metallische Kontaktfeder 56 hat auf der vom Kunststoffbügel 15 abgewandten Seite ein halbkreisförmiges federndes Bogenstück 58. Auf der Grundplatte 36 sind ferner vier mit ihr einstückig verbundene Klemmrippen 40 ausgebildet. Beim Zusammenbau wird zunächst das Rastelement 48 mit an entsprechenden Stellen vorgesehenen Öffnungen 50 über die Klemmrippen 40 gesteckt. Dadurch wird das Rastelement 48 lagerichtig fixiert. Anschließend werden Klemmschlitze 60 der Kontaktfeder 56 auf die Klemmrippen 40 gesteckt und die Kontaktfeder 56 mit der Grundplatte 36 durch Andrücken der Kontaktfeder 56 gegen die Grundplatte 36 verklemmt.

Die Federeigenschaften der Kontaktfeder 56 bewirken, daß die Klemmschlitze 60, deren jeweilige Öffung geringfügig kleiner als die Breite der entsprechenden Klemmrippe 40 ist, beim Andrücken in Aufsteckrichtung unter Federdruck über die Klemmrippen 40 gleiten, wobei der Rand der Öffnung leicht in umgekehrter Richtung gebogen wird. Wenn die Kontaktfeder 56 entgegen der Aufsteckrichtung bewegt wird, so greift der umgebogene Rand mit seiner Kante in das elastische Material der entsprechenden Klemmrippe 40 und verformt es. Eine weitere Bewegung entgegen der Aufsteckrichtung wird somit verhindert. Die durch die Deformierung des Randes entstehende Federkraft spannt die Kontaktfeder 56 in Aufsteckrichtung vor, so daß sie nach dem Aufstecken federnd gegen die Grundplatte 36 gehalten wird. Auf weitere Befestigungsmittel kann bei dieser Art der Befestigung verzichtet werden.

Beim Aufstecken der Kontaktfeder 56 wird das Rastelement federnd eingeklemmt. Die Elastizität der Kontaktfeder 56 kann die Federwirkung der Raste 52 mit unterstützen. Rastelement 48 und Kontaktfeder 56 können dabei ihre Funktionen unabhängig voneinander ausführen.

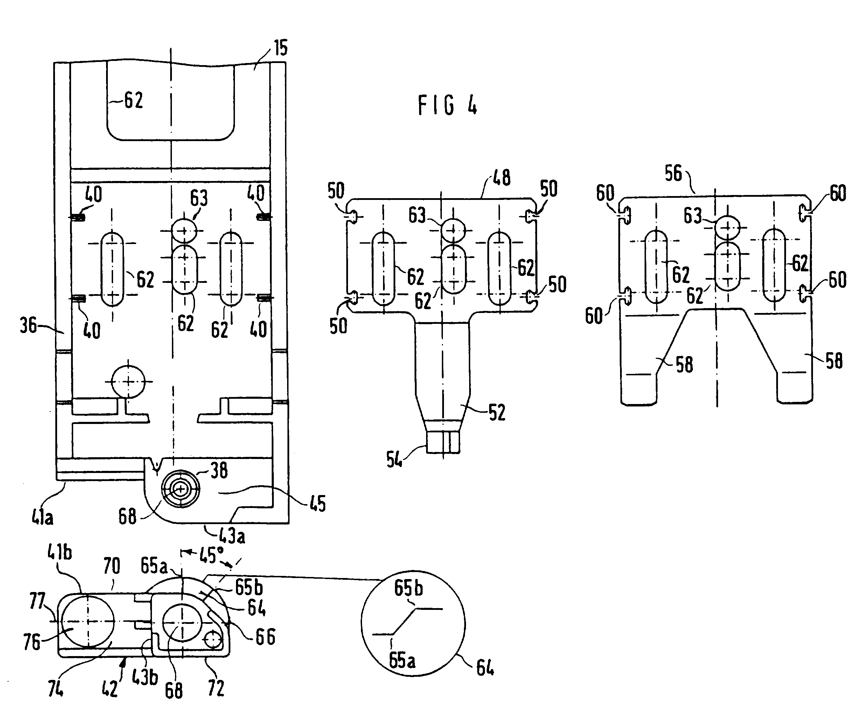

In Fig. 4 ist eine Draufsicht von der Außenseite des Kunststoffbügels 15 auf die Verriegelungsvorrichtung 34 dargestellt, wobei die einzelnen Bauteile in demontierten Zustand gezeigt sind. Die Grundplatte 36 hat eine Sitzfläche 45, auf der der Entsperrhebel 42 aufliegen kann. Weiterhin enthält sie Durchbrüche 62, die für die Aufnahme bzw. die Befestigung des elektrischen Gerätes 18 dienen. Solche Durchbrüche 62 sind an entsprechenden Stellen auch im Rastelement 48 und in der Kontaktfeder 56 vorgesehen. Die Bauteile 36, 48 und 56 enthalten jeweils ein Bohrloch 63, durch das das elektrische Gerät 18 mittels einer Schraube leitend mit der Kontaktfeder 56 verbunden werden kann.

Der Entsperrhebel 42 ist bezüglich seiner Schwenkachse 68 in einen ersten Hebelabschnitt 72 und einen zweiten Hebelabschnitt 70 aufgeteilt. Der zweite Hebelabschnitt 70 dient als Griff 74 und hat eine Griffmulde 76, so daß der Griff 74 fest zwischen den Fingern einer Bedienperson gefaßt werden kann. Der erste Hebelabschnitt 72 hat einen rampenförmigen Axialnocken 64 mit einem Anfangsabschnitt 65a und einem Endabschnitt 65b. Der als Ausschnitt unten in Fig. 4 schematisch vergrößert dargestellte Axialnocken 64 überdeckt einen Drehwinkelvon ca. 45°. Der einen Hub der Raste 52 bewirkende Abschnitt 65 des Axialnockens 64 beginnt nach einem Schwenkwinkel von 90° gegen die Längsachse 77 des Entsperrhebels 42. Ferner ist der erste Hebelabschnitt 72 mit einem Radialnocken 66 versehen, dessen Steuerkurve etwa in Höhe des Endabschnitts 65b beginnt. Der Radialnocken 66 erreicht seinen maximalen Hub etwa bei einem Schwenkwinkel von 180° gegen die Längsachse 77 des Entsperrhebels 42.

Wenn der Entsperrhebel 42 in der in Fig. 4 gezeigten Stellung auf den Zapfen 38 gesteckt wird, so nimmt er seine Ruhestellung ein. In dieser Stellung schlägt seine Kante 41b gegen eine Kante 41a der Grundplatte 36 an. Aus dieser Ruhestellung kann der Entsperrhebel 42 im Gegenuhrzeigersinn um 90° geschwenkt werden und befindet sich dann in der Ausziehstellung. In dieser Stellung schlägt eine auf der Unterseite des Entsperrhebels 42 vorgesehene Anschlagkante 43b gegen die Kante 43a der Grundplatte 36 und begrenzt so die Schwenkbewegung.

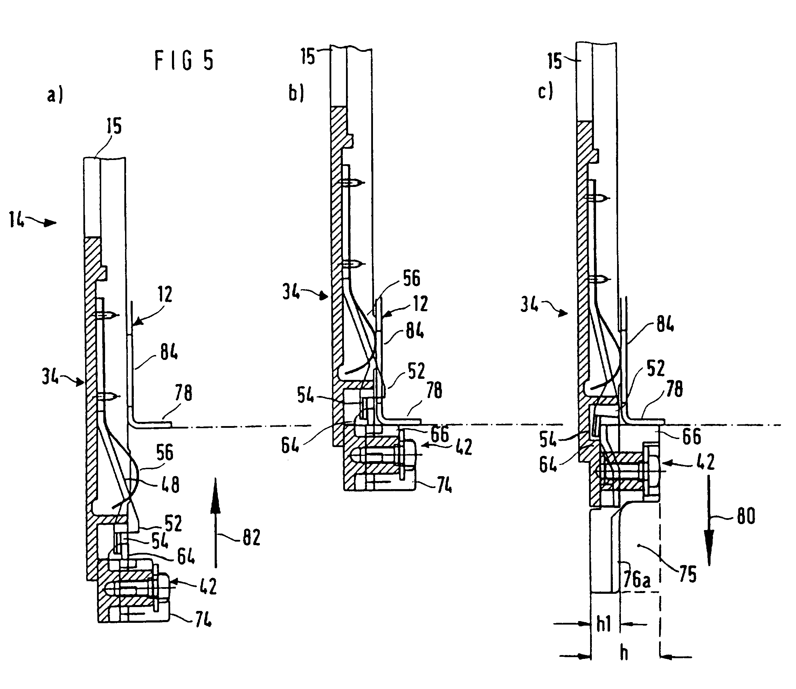

In Fig. 5 wird die Verriegelungsvorrichtung 34 zusammen mit dem vorderen Abschnitt des Einschubrahmens 12 in drei Stellungen a bis c gezeigt. In Stellung a ist die Einschubeinheit 14 um eine Weglänge aus dem Einschubrahmen 12 herausgezogen. Die Raste 52 ist dann aus einem Teil des Einschubrahmens 12, der eine Rastöffung 84 und ein durch eine Vorderkante des Einschubrahmens 12 gebildetes Gegenlager 78 umfaßt, gelöst. Wenn die Einschubeinheit 14 in Richtung des Pfeiles 82 in den Einschubrahmen 12 eingeschoben wird, so rastet die Raste 52 in die Rastöffnung 84 ein und verriegelt die Einschubeinheit 14 mit dem Einschubrahmen 12. In dieser Stellung b drückt die Kontaktfeder 56 gegen den Einschubrahmen 12 und stellt so einen elektrischen Kontakt her.

Zum Herausziehen der Einschubeinheit 14 aus dem Einschubrahmen 12 wird der Entsperrhebel 42 von einer Bedienperson am Griff 74 gefaßt und um 90° geschwenkt, wie in Stellung c der Fig. 5 zu sehen ist. Bei dieser Schwenkbewegung greift der Axialnocken 64 mit seinem rampenförmigen Abschnitt an der Nase 54 des Rastelements 48 an und bewegt die Raste 52 aus der Rastöffnung 84. Im weiteren Verlauf der Schwenkbewegung wird der Radialnocken 66 gegen das Gegenlager 78 gedrückt, so daß die Einschubeinheit 14 aus dem Einschubrahmen 12 in Richtung des Pfeils 80 um den Einsteckweg der Steckvorrichtung 28, 30 herausgedrückt wird.

In der völlig herausgeschwenkten Stellung des Entsperrhebels 42 ist zu erkennen, daß der Griff 74 flach ausgebildet ist und an seiner Oberseite einen Griffsteg 76a hat. Dieser wird zum Herausschwenken des Griffs 74 von der Bedienperson in Ruhestellung des Entsperrhebels 42 gegriffen. Die Höhe h1 des Griffs 74 ist wesentlich geringer als die Gesamthöhe h des Entsperrhebels 42. In der Ruhestellung des Entsperrhebels 42 (vgl. Stellung b) wird somit zwischen dem Einschubrahmen 12 und der Einschubeinheit 14 ein Raum (angedeutet mit Bezugsziffer 75) gebildet, in den ein innenliegendes Türscharnier einer vom Einschubrahmen 12 gehaltenen Tür hineinragen kann. Beim Öffnen der Tür gibt das Türscharnier den Raum 75 frei, so daß eine Eingriffsöffnung für den Finger einer Bedienperson zum Griffsteg 76a geschaffen wird. Durch diese konstruktiven Maßnahmen wird der Raum im Einschubrahmen 12 optimal genutzt.

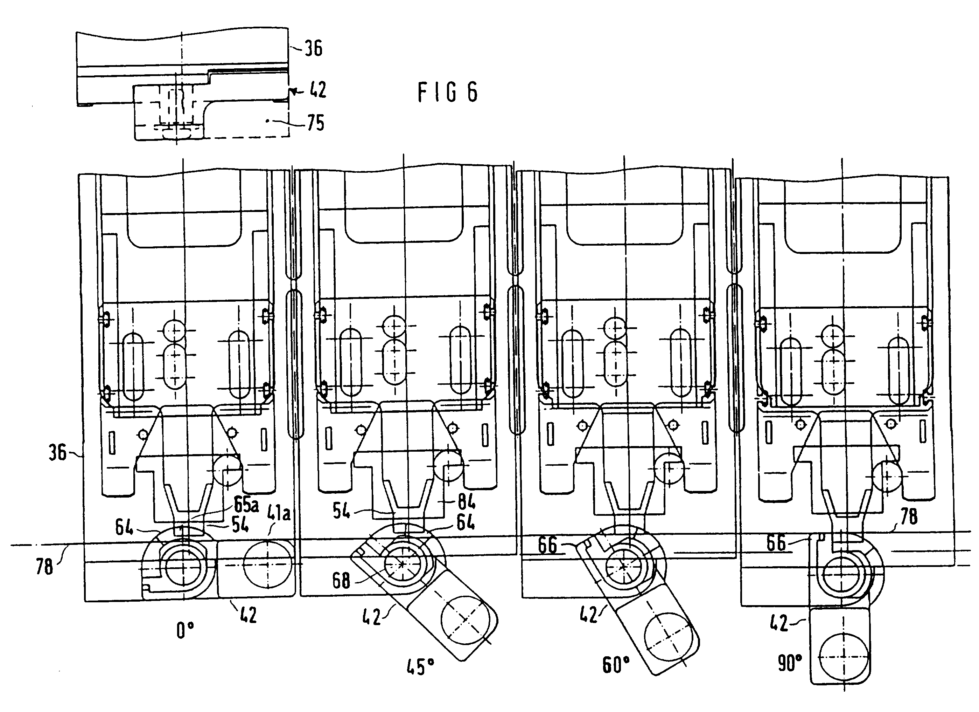

In Fig. 6 ist die Verriegelungsvorrichtung 34 in vier Schwenkstellungen des Entsperrhebels 42 mit Drehwinkeln von 0° bis 90° dargestellt. Beim Drehwinkel 0° befindet sich der Entsperrhebel 42 in Ruhestellung. In dieser Stellung drückt die unter Federkraft stehende Nase 54 des Rastelements 48 gegen den Anfangsabschnitt 65a des rampenförmigen Axialnockens 64. Dadurch wird auf den Entsperrhebel 42 ein Drehmoment ausgeübt, das diesen gegen die Kante 41a der Grundplatte 36 leicht andrückt. Selbst wenn in Ruhestellung der Entsperrhebel 42 einen Drehwinkel größer als 0° gegen die Vorderkante der Grundplatte 36 einnehmen würde, was beispielsweise bei nicht sorgfältigem Einschieben der Einschubeinheit 14 in den Einschubrahmen 12 geschehen kann, so würde das von der Nase 54 am Axialnocken 64 erzeugte Drehmoment den Entsperrhebel 42 in seine Ruhestellung bewegen. Damit wird die Einnahme der Ruhestellung unterstützt. Dadurch ist sichergestellt, daß der Entsperrhebel 42 beim Schließen der Schranktür nicht stört oder sogar beschädigt wird. Im oberen Bildteil ist der Raum 75 zu erkennen, der durch die verringerte Höhe des Griffs 74 gebildet wird.

Bei einem Drehwinkel von 45° hat der rampenförmige Axialnocken 44 seinen größten Hub, der ausreicht, um die Raste 52 aus der Rastöffung 84 herauszubewegen. In dieser Stellung drückt der Radialnocken 66 gerade noch nicht gegen das Gegenlager 78. Beim Drehwinkel 60° befindet sich der Radialnocken 66 in Eingriff mit dem Gegenlager 78 und hat die Einschubeinheit 14 bereits um einen kleinen Weg aus dem Einschubrahmen 12 herausgehebelt. Beim Drehwinkel 90° erreicht der Radialnocken 66 seinen maximalen radialen Hub. In dieser Stellung sind die Kontakte des Steckverbinders 28 der Einschubeinheit 14 um einen Kontaktweg, beispielsweise 5 bis 10 mm, aus der Steckbuchse 30 herausgezogen. Durch die Hebelwirkung des Radialnockens 66 lassen sich die anfänglich hohen Kontaktkräfte der Steckverbindung 28, 30 leicht überwinden, so daß die Ausziehbewegung ruckfrei erfolgt.

## Patentansprüche

1. Vorrichtung zum Entsperren eines federnd vorgespannten Rastelements an der Seite einer elektronischen Einschubeinheit, die im in einem Baugruppenträger eingeschobenen Zustand über ein Steckverbindungssystem mit diesem verbunden ist, das in Richtung der Ausziehbewegung der Einschubeinheit lösbar ist, mit einem an der Seite der Einschubeinheit schwenkbar gelagerten Entsperrhebel, der durch seine Schwenkbewegung mit einem ersten Hebelabschnitt das Rastelement gegen die Federkraft aus einer Rastöffnung drückt und mit einem zweiten Hebelabschnitt in eine aus der Frontseitenebene der Einschubeinheit herausragende Stellung gebracht wird, dadurch **gekennzeichnet,** daß der erste Hebelabschnitt (72) einen Axialnocken (64) hat, dessen Axialhub mindestens gleich dem Bewegungshub des Rastelements (48) zwischen dessen Einrast- und Entsperrstellung ist und der mit dem Rastelement (48) in Eingriff steht, und daß der erste Hebelabschnitt (72) ferner einen Radialnocken (66) hat, der gegen ein mit dem Baugruppenträger (12) verbundenes Gegenlager (78) bewegbar ist und der einen Nockenhub hat, welcher in einem vorgegebenen Verhältnis zum Kontaktweg des Steckverbindungssystems (28, 30) steht.

2. Vorrichtung nach Anspruch 1, dadurch **gekennzeichnet**, daß der Nockenhub des Radialnocken (66) gleich dem Kontaktweg des Steckverbindungssystems ist.

3. Vorrichtung nach Anspruch 1 oder 2, dadurch **gekennzeichnet**, daß die Schwenkbewegung des Entsperrhebels (42) durch Anschläge (41a, 41b, 43a, 43b) auf einen Schwenkbereich von vorzugsweise 90° beschränkbar ist.

4. Vorrichtung nach einem der vorhergehenden Ansprüche, dadurch **gekennzeichnet,** daß der Entsperrhebel (42) auf der Außenseite der Einschubeinheit (14) angeordnet ist und im eingeschobenen Zustand der Einschubeinheit (14) etwa bündig mit der Frontseitenebene abschließt.

5. Vorrichtung nach einem der vorhergehenden Ansprüche, dadurch **gekennzeichnet,** daß im eingeschobenen Zustand der Einschubeinheit (14) eine Nase (54) des Rastelements (48) einem Anfangsabschnitt (65a) des rampenförmigen Axialnockens (64) gegenübersteht, und daß der wirksame Abschnitt des Axialnokkens (64) einen Drehwinkel von ca. 45° überdeckt.

6. Vorrichtung nach einem der vorhergehenden Ansprüche, dadurch **gekennzeichnet,** daß der zweite Hebelabschnitt (70) auf mindestens einer Seite eine muldenförmige Vertiefung (76) und/oder einen Griffsteg (76a) hat.

7. Vorrichtung nach einem der vorgehenden Ansprüche, dadurch **gekennzeichnet,** daß an der Außenseite der Einschubeinheit (14) eine metallische Kontaktfeder (56) vorgesehen ist, die mit dem metallischen Baugruppenträger (12) federnd in Kontakt steht und die mit einem von der Einschubeinheit (14) gehaltenen Gerät (18) leitend verbindbar ist.

8. Vorrichtung nach Anspruch 7 dadurch **gekennzeichnet**, daß das Rastelement (48) zwischen der Außenseite der Einschubeinheit (14) und der Kontaktfeder (56) einklemmbar ist.

9. Vorrichtung nach einem der Ansprüche 7 oder 8, dadurch **gekennzeichnet,** daß auf der Außenseite der Einschubeinheit (14) Klemmrippen (40) vorgesehensind, auf die die Kontaktfeder (56) klemmend aufsteckbar ist.

10. Vorrichtung nach einem der vorhergehenden Ansprüche, dadurch **gekennzeichnet,** daß die Einschubeinheit (14) als U-förmiger Kunststoffbügel (15) ausgebildet ist, der durch Spritzgießen herstellbar ist.

11. Vorrichtung nach einem der vorhergehenden Ansprüche, dadurch **gekennzeichnet,** daß der Kunststoffbügel (15) an seiner Basis (24) ein Verbindungselement (28) trägt, das mit einem zugehörigen Verbindungselement (30) des Baugruppenträgers (12) verbindbar ist, und daß das Rastelement (48) im vorderen, von der Basis (24) entfernten Abschnitt mindestens eines Schenkels (26) des Kunststoffbügels (15) vorgesehen ist.

12. Vorrichtung nach einem der vorhergehenden Ansprüche, dadurch **gekennzeichnet,** daß die Einschubeinheit (14) Aufnahmeelemente (62, 63) für ein Gerät in Form von kreisförmigen und/oder schlitzförmigen Durchbrüchen hat.

13. Vorrichtung nach einem der vorhergehenden Ansprücher dadurch **gekennzeichnet,** daß der zweite Hebelabschnitt (70, 74) in seiner Höhe (hl) gegenüber der Gesamthöhe (h) des Entsperrhebels (42) verringert ist.

14. Vorrichtung nach einem der vorhergehenden Ansprüche, dadurch **gekennzeichnet,** daß die Einschubeinheit (14) ein Magnetplattenlaufwerk oder ein Magnetbandlaufwerk aufnimmt.

## Claims

1. Means for unlocking a resiliently prestressed latching element on the side of an electronic push-in unit, which latching element, once the push-in unit has been pushed into a rack, is connected to the latter via a plug-in connection system which can be released in the direction of the drawing-out movement of the push-in unit, having an unlocking lever which is mounted pivotally on the side of the push-in unit, forces, by virtue of its pivot movement, the latching element out of a latching opening, counter to the spring force, by means of a first lever section and, by means of a second lever section, is brought into a position in which it projects from the front plane of the push-in unit, characterized in that the first lever section (72) has an axial cam (64), of which the axial displacement is at least equal to the displacement of the latching element (48) between its latched-in position and unlocked position and which is in engagement with the latching element (48), and in that the first lever section (72), furthermore, has a radial cam (66) which can be moved against an abutment (78) connected to the rack (12) and has a cam displacement which is at a predetermined ratio with respect to the contact path of the plug-in connection system (28, 30).

2. Means according to Claim 1, characterized in that the cam displacement of the radial cam (66) is equal to the contact path of the plug-in connection system.

3. Means according to Claim 1 or 2, characterized in that the pivot movement of the unlocking lever (42) can be restricted, by stops (41a, 41b, 43a, 43b), to a pivot range of preferably 90°.

4. Means according to one of the preceding claims, characterized in that the unlocking lever (42) is arranged on the outside of the push-in unit (14) and, once the push-in unit (14) has been pushed in, terminates approximately flush with the front plane.

5. Means according to one of the preceding claims, characterized in that, once the push-in unit (14) has been pushed in, a nose (54) of the latching element (48) is located opposite an initial section (65a) of the ramp-like axial cam (64), and in that the active section of the axial cam (64) covers a rotational angle of approximately 45°.

6. Means according to one of the preceding claims, characterized in that, on at least one side, the second lever section (70) has a hollow-like depression (76) and/or a grip web (76a).

7. Means according to one of the preceding claims, characterized in that the push-in unit (14) has provided on its outside a metallic contact spring (56) which is in resilient contact with the metallic rack (12) and can be connected in a conductive manner to a device (18) retained by the push-in unit (14).

8. Means according to Claim 7, characterized in that the latching element (48) can be clamped in between the outside of the push-in unit (14) and the contact spring (56).

9. Means according to one of Claims 7 or 8, characterized in that the push-in unit (14) has provided on its outside clamping ribs (40) onto which the contact spring (56) can be plugged in a clamping manner.

10. Means according to one of the preceding claims, characterized in that the push-in unit (14) is designed as a U-shaped plastic bracket (15) which can be produced by injection moulding.

11. Means according to one of the preceding claims, characterized in that, on its base (24), the plastic bracket (15) bears a connection element (28) which can be connected to an associated connection element (30) of the rack (12), and in that the latching element (48) is provided in the front section of at least one leg (26) of the plastic bracket (15), said front section being remote from the base (24).

12. Means according to one of the preceding claims, characterized in that the push-in unit (14) has receiving elements (62, 63) which are intended for a device and are in the form of circular and/or slot-shaped through-passages.

13. Means according to one of the preceding claims, characterized in that the height (hl) of the second lever section (70, 74) is reduced in comparison with the overall height (h) of the unlocking lever (42).

14. Means according to one of the preceding claims, characterized in that the push-in unit (14) receives a magnetic disk drive or a magnetic tape drive.

## Revendications

1. Dispositif destiné au déverrouillage d'un élément d'encliquetage précontraint élastiquement sur le côté d'un tiroir électronique enfichable, qui, à l'état inséré dans un support de modules, est relié à ce dernier par un système de liaison à enfichage qui est amovible dans le sens du mouvement de retrait du tiroir enfichable, comportant un levier de déverrouillage qui est monté de façon à pouvoir pivoter sur le côté du tiroir enfichable, qui avec un premier tronçon de levier pousse par son mouvement de pivotement l'élément d'encliquetage hors d'un orifice d'encliquetage en s'opposant à la force élastique, et qui est placé dans une position dépassant du plan de la face frontale du tiroir enfichable par un deuxième tronçon de levier, b le premier tronçon (72) de levier comporte une came axiale (64) dont la course axiale est au moins égale à la course de mouvement de l'élément d'encliquetage (48) entre ses positions encliquetée et déverrouillée, et qui est en prise avec l'élément d'encliquetage (48), et par le fait que le premier tronçon (72) de levier comporte en outre une came radiale (66), qui peut être déplacée en direction d'une contrebutée (78) reliée au support de modules (12), et dont la course de came est dans un rapport prédéterminé vis-à-vis de la longueur de contact du système de liaison à enfichage (28, 30).

2. Dispositif selon la revendication 1, **caractérisé par le fait que** la course de la came radiale (66) est égale à la longueur de contact du système de liaison à enfichage.

3. Dispositif selon la revendication 1 ou 2, **caractérisé par le fait que** le mouvement de pivotement du levier de déverrouillage (42) peut être limité par des butées (41a, 41b, 43a, 43b) à une plage de pivotement qui est de préférence de 90°.

4. Dispositif selon l'une quelconque des revendications précédentes, **caractérisé par le fait que** le levier de déverrouillage (42) est disposé sur la face extérieure du tiroir enfichable (14) et que, à l'état inséré du tiroir enfichable (14) , il se termine approximativement à affleurement avec le plan de la face avant.

5. Dispositif selon l'une quelconque des revendications précédentes, **caractérisé par le fait que**, à l'état inséré du tiroir enfichable (14), un taquet (54) de l'élément d'encliquetage (48) est situé en face d'un tronçon de départ (65a) de la came axiale (64) en forme de rampe, et par le fait que le tronçon actif de la came axiale (64) couvre un angle de rotation de l'ordre de 45°.

6. Dispositif selon l'une quelconque des revendications précédentes, **caractérisé par le fait que** le deuxième tronçon (70) de levier comporte, d'un côté au moins, un renfoncement (76) en forme d'évidement et/ou une barrette (76a) de poignée.

7. Dispositif selon l'une quelconque des revendications précédentes, **caractérisé par le fait qu'**un ressort métallique de contact (56) est prévu sur la face extérieure du tiroir enfichable (14), qui est en contact élastique avec le support de modules (12) métallique, et qui peut être relié de façon conductrice à un appareil (18) retenu par le tiroir enfichable (14).

8. Dispositif selon la revendication 7, **caractérisé par le fait que** l'élément d'encliquetage (48) peut être coincé entre la face extérieure du tiroir enfichable (14) et le ressort de contact (56).

9. Dispositif selon l'une des revendications 7 ou 8, **caractérisé par le fait que** des nervures de blocage (40) sont prévues sur la face extérieure du tiroir enfichable (14), sur lesquelles le ressort de contact (56) peut être emboîté par blocage.

10. Dispositif selon l'une quelconque des revendications précédentes, **caractérisé par le fait que** le tiroir enfichable (14) est réalisé en tant qu'étrier (15) en forme de U en matière plastique pouvant être fabriqué par moulage par injection.

11. Dispositif selon l'une quelconque des revendications précédentes, **caractérisé par le fait que,** au niveau de sa base (24), l'étrier (15) en matière plastique porte un élément de liaison (28), qui peut être relié à un élément de liaison (30) associé du support de modules (12), et par le fait que l'élément d'encliquetage (48) est prévu dans la partie avant éloignée de la base (24) d'au moins une branche (26) de l'étrier (15) en matière plastique.

12. Dispositif selon l'une quelconque des revendications précédentes, **caractérisé par le fait que** le tiroir enfichable (14) est pourvu d'éléments de réception (62, 63) destinés à un appareil, qui sont réalisés sous la forme de traversées circulaires et/ou en forme de fentes.

13. Dispositif selon l'une quelconque des revendications précédentes, **caractérisé par le fait que** la hauteur (h1) du deuxième tronçon (70, 74) de levier est réduite par rapport à la hauteur totale (h) du levier de déverrouillage (42).

14. Dispositif selon l'une quelconque des revendications précédentes, **caractérisé par le fait que** le tiroir enfichable (14) reçoit un mécanisme d'entraînement de disque magnétique ou de bande magnétique.
